Europäisches Patentamt

European Patent Office

Office européen des brevets

(11) Publication number: **0 413 354 A1**

## (12) EUROPEAN PATENT APPLICATION

(21) Application number: 90115806.3

(22) Date of filing: 17.08.90

(51) Int. Cl.⁵: **C23C 14/34**

(30) Priority: 17.08.89 JP 211974/89
17.08.89 JP 211975/89
17.08.89 JP 211976/89
14.09.89 JP 238637/89

(43) Date of publication of application:
**20.02.91 Bulletin 91/08**

(84) Designated Contracting States:
**DE FR GB NL**

(71) Applicant: **MITSUBISHI KASEI CORPORATION**
**5-2, Marunouchi 2-chome Chiyoda-ku**
**Tokyo 100(JP)**

(72) Inventor: **Kisaka, Yoshiyuki**
**3-1-75-21 Hiroe**
**Kurashiki-shi, Okayama-ken(JP)**
Inventor: **Tamura, Takanori**
**A-103 287-3 Miyamae**
**Kurashiki-shi, Okayama-ken(JP)**
Inventor: **Nishimura, Naoki**
**6460 Nakano, Asahi-cho**
**Takao-shi, Saga-ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Sputtering target for DC magnetron reactive sputtering, process for forming thin layer by use of the target, and optical disk having a layer formed by the process.

(57) The present invention provides a target for use in DC magnetron sputtering, which is formed to be placed on the upper surface of a backing plate (6) in a DC magnetron reactive sputtering apparatus and comprises a target member (1) to be sputtered and a plurality of electrically insulating members (4,5) provided to coat the upper surface of the target memebr (1) or the upper surface of the backing plate (6) so as to prevent the deposition of a metal compound or a nonmetal compound formed by DC magnetron reactive sputtering on non-sputter areas (3) of the target member (1). By the use of the target according to the present invention, sputtering films with less defects can be obtained stably, thereby largely improving the productivity of an optical disk, etc.

*Fig. 1*

EP 0 413 354 A1

# SPUTTERING TARGET FOR DC MAGNETRON REACTIVE SPUTTERING, PROCESS FOR FORMING THIN LAYER BY USE OF THE TARGET, AND OPTICAL DISK HANG A LAYER FORMED BY THE PROCESS

## BACKGROUND OF THE INVENTION:

The present invention relates to a target for use in DC magnetron reactive sputtering. More specifically, it relates to a sputtering target enabling DC magnetron reactive sputtering excellent in stable discharge. The present invention further relates to a process for forming a thin layer by use of the sputtering target and a optical disk having a layer formed by use of the sputtering target.

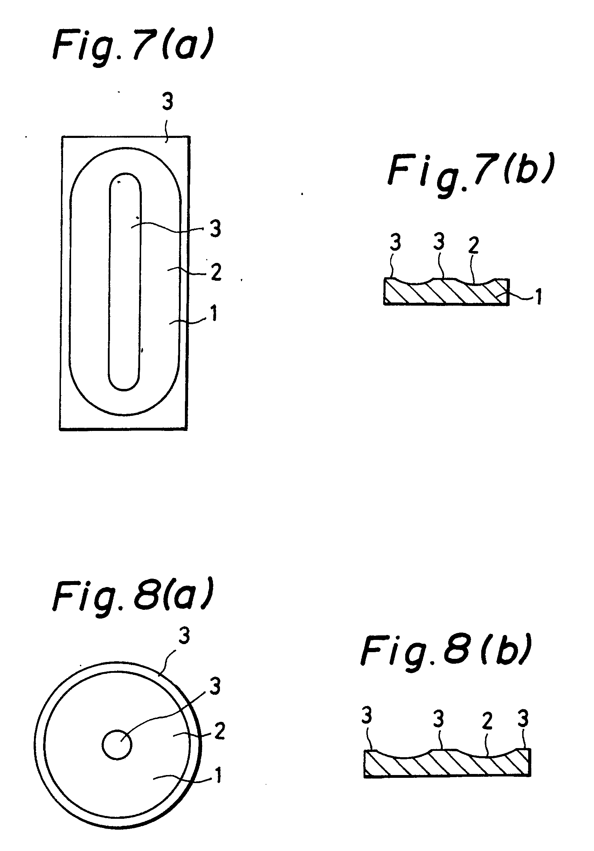

As a method of forming a thin film of a metal oxide or a metal nitride by means of sputtering on a substrate, has been broadly used a reactive sputtering where a sputtered target substance and a sputtering gas (hereinafter referred to as "reactive gas") are chemically reacted thereby forming on a substrate a thin film of a resultant compound of the reaction. In the present invention, the reactive sputtering as described above which carried out by using a DC magnetron sputtering apparatus is referred to as a DC magnetron reactive sputtering. When a thin film of a metal compound is formed on a substrate by means of DC magnetron reactive sputtering, as shown in Figs. 7 and 8, the area 2 in which sputtering of a target substance is predominant (sputter area 2) and the area 3 in which the formation of a metal compound is predominant (non-sputter area 3) are present on a target depending on the difference between the sputtering rate of the target substance and the forming rate of the metal compound on the target.

In the non-sputter area 3, an electrically insulating thin film of the metal compound is gradually deposited on the surface of the target. The insulating thin film thus formed causes dielectric breakdown at thin and fragile portions to generate sparks thereby bringing about abnormal discharge, when sputtering is conducted continuously. Further, when the deposited film causes dielectric breakdown, overcurrent flows through the breakdown portion to scatter small lumps of molten material, which adhere to the thin film being formed on the surface of a substrate to result in defects.

It is, accordingly, necessary to remove an electrically insulating thin film deposited on the surface of a target at regular intervals for avoiding the above problems. For removing the thin film on the target, the sputtering should be interrupted to return the pressure inside the sputtering apparatus to atmospheric pressure, this being inefficient, in particular, leading to a remarkable reduction in the productivity when an in-line type sputtering apparatus is used.

It is an object of the present invention to solve the foregoing problems in the target for use in forming a thin film of a metal compound, etc., by DC magnetron reactive sputtering, thereby improving the production efficiency.

The present inventors have made extensive studies for solving the problems and, as a result, found that abnormal electric discharge during sputtering can be remarkably reduced and a sputter thin film of less defects can be obtained when a target of a particular structure is used. The present invention has been accomplished based on this finding.

## SUMMARY OF THE INVENTION:

The present invention provides a sputtering target for DC magnetron reactive sputtering, which is formed to be placed on the upper surface of a backing plate in a DC magnetron reactive sputtering apparatus and comprises a target member to be sputtered and a plurality of electrically insulating members provided to coat the upper surface of the target member or the upper surface of the backing plate so as to prevent the deposition of a metal compound or a nonmetal compound formed by DC magnetron reactive sputtering on non-sputter areas of the target member.

The present invention further provides a process for forming a thin film of a metal compound on a substrate surface by DC magnetron reactive sputtering, in which the target as defined above is used.

The present invention still further provides an optical disk having a metal compound layer formed by the process as defined above.

## BRIEF DESCRIPTION OF THE DRAWINGS:

Fig. 1 shows a longitudinal cross sectional view of a target of the present invention in use on a backing plate (6), the target having an electrically insulating film on the surface of a non-sputter area thereof.

Fig. 2 shows a longitudinal cross sectional view of another target of the present invention in use on a backing plate, the non-sputter area of the target member being constituted with electrically insulating integral members.

Fig. 3 shows a longitudinal cross sectional view of another target of the present invention in use on a backing plate, the electrically insulating film having bevels at the edges facing to the sputter area.

Fig. 4 shows an enlarged fragmentary cross sectional view showing part of the electrically insulating film structure in Fig. 3.

Fig. 5 shows a longitudinal cross sectional view of still another target of the present invention in use on a backing plate, the target member further having electrically insulating members which coat the side faces of the target member and the upper surface of a backing plate around the target when placed on the backing plate.

Fig. 6 shows a longitudinal cross sectional view of the target in Fig. 5 which is mounted on a backing plate covered with an earth shield member.

Fig. 7 (a) and (b), and Fig. 8 (a) and (b) show, respectively, plan views and cross sectional views of conventional targets.

In the drawings, numerical 1 is a target member, 2 is a sputter area, 3 is a non-sputter area, 4 is an electrically insulating film, $4'$ and $4''$ are electrically insulating members, 5 is an adhesive layer, 6 is a backing plate, 7 is electrically insulating integral member and 8 is an earth shield.


## DETAILED DESCRIPTION OF THE INVENTION:

The target according to the present invention will be explained more specifically with reference to the drawings.

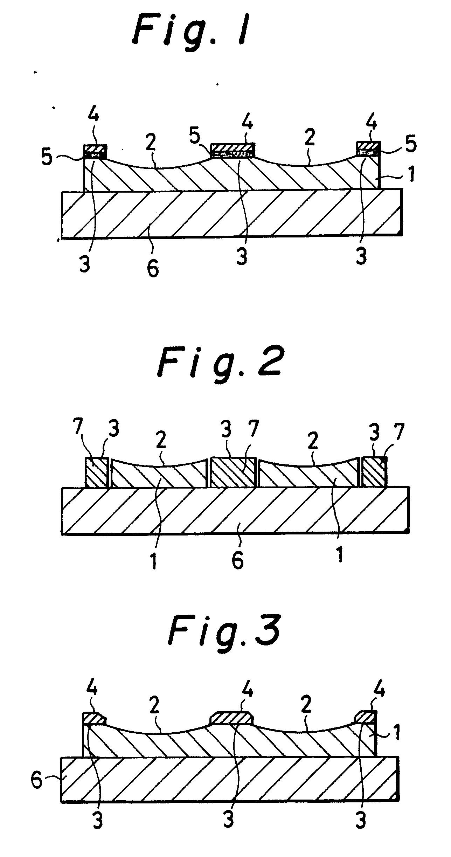

Figs. 1 to 6 are longitudinal cross sectional views for one embodiment of a target according to the present invention.

As the target member 1, there may be used any of known materials that can be sputtered by means of DC magnetron sputtering and there may be mentioned, for example, metals such as Al, Ti, V, Cr, Mn, Fe, Co, Ni, Cu ,Zn, Ge, Zr, Nb, Mo, Ru, Rh, Pb, Ag, Hf, Ta, W, Re, Os, Ir, Pt, Au and Th, nonmetals such as C, Si, Se, Te and Ge, as well as compounds of them. As the reactive gas, any of gases capable of reacting with the target substance described above to form compounds may be used and there can be mentioned, for example, $H_2$, $N_2$, $O_2$, $F_2$, $Cl_2$, $CH_4$, $C_2H_4$, $CF_4$ and $C_2F_4$.

In a case of forming a compound film by means of DC magnetron type reactive sputtering by using a target and the reactive gas, sputtering is not or less taken place at the portions where the vertical ingredient of the magnetic field of the magnets is large. In these portions (non-sputter area 3), a compound formed from the target substance and the reactive gas are deposited, on the contrary, to reduce the electroconductivity, and cause dielectric breakdown as described above.

In the target according to the present invention, the non-sputter area 3 is coated with the insulating material or is constituted with the insulating material.

As the insulating material, there can be mentioned glass plate, pottery plate and ceramic plate as the typical examples but any of electrically insulating materials may be used.

It is only necessary for the electrically insulating film 4 to have such a thickness as causing no dielectric breakdown during sputtering, and the thickness may be about 50 $\mu$m, preferably, not less than 150 $\mu$m and, more preferably, not less than 300 $\mu$m. In view of the handling upon coating, thickness from 1 to 5 mm is preferably employed.

The electrically insulating film 4 may be made into a form of plate and is usually attached by means of the adhesive 5 or screws (not illustrated in the figures) to the target member 1. This is because a certain extent of strength is required in view of handling properties.

The adhesive 5 or screw used in this case is required to be electrically insulating and an adhesive, for example, made of aluminum paste or a screw made of ceramics is preferably used.

In addition to attaching methods using the adhesive or screw, a method of coating a liquid insulating material and then solidifying it may be used for providing the electrically insulating film 4 on the non-sputter surface of the target member 1.

Since the position of coating the insulating material varies depending on the shape of a target, the shape and the size of electrode or magnet, it can be determined in accordance with them. As shown in Figs. 7 and 8, for instance, there are various shapes for the target.

The electrically insulating integral member 7 made of insulating materials is disposed, as shown in Fig. 2, at the central portion and peripheral portion of the target member 1 (around the sputter area 2) corresponding to the non-sputter area 3. The shape of the electrically insulating integral member 7 varies depending on the shape of the target member 1, the shape and the size of the electrode and magnet, etc.

Since it is only necessary for the electrically insulating integral member 7 to have such a thickness as not causing dielectric breakdown, the thickness may be usually of about 50 $\mu$m, preferably, not less than 150 $\mu$m and, more preferably, not less than 300 $\mu$m. In view of the handling, the member having a thickness equal to that of the target member 1 is preferably used.

The electrically insulating member 7 is made into a predetermined shape and the size according to those of the non-sputter areas and usually attached to the target member 1 by means of an adhesive or screw (not illustrated).

Also in this case, the adhesive or the screw is required to be made of an insulating material, for example, an adhesive made of aluminum paste or screw made of ceramic is preferably used.

By using the target as described above, abnormal electric discharge during sputtering can remarkably be reduced. However, it has been found that injection of ions for sputtering the target (inert gas such as argon) is partially interrupted by the electrically insulating film at the boundary between the electrically insulating film such as glass and the target member, and as a result, an insulating compound formed by sputtering is deposited to cause abnormal electric discharge during continuous operation over a long period of time.

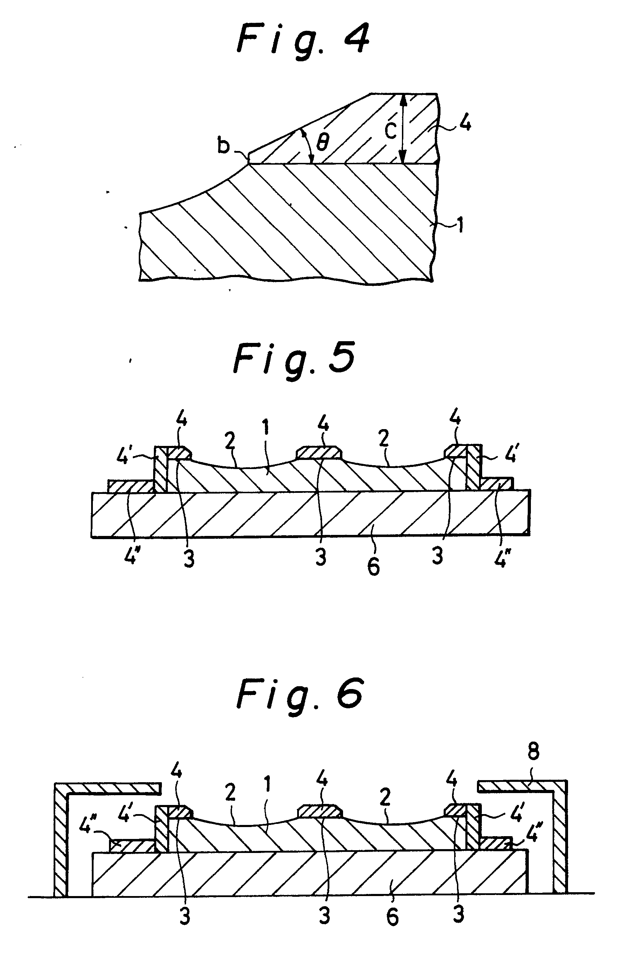

The present inventors have found that such abnormal electric discharge during long time sputtering can be prevented by providing bevels at the circumferential edges of the electrically insulating film 4 on the side facing to the sputter areas (Figs. 3 and 4).

As shown in an enlarged cross sectional view thereof in Fig. 4, the angle of increnation $\theta$ between the bevel surface and the target member surface is usually not greater than $60°$, preferably, within a range from 20 to $60°$ and, more preferably, from 30 to $40°$. If the angle of inclination $\theta$ is too large, the effect of preventing abnormal electric discharge is reduced. The thickness at the lower end of the bevel (b in Fig. 4) is usually of not less than 0.01 mm, preferably, not less than 0.1 mm and, more preferably, not less than 0.2 mm. Further, the thickness at the upper flat portion (c in Fig. 4) of the electrically insulating film is usually of not less than 1 mm and, preferably, within a range from 1 to 3 mm.

Further, it has also been found by the present inventors that abnormal electric discharge would be taken place if the insulating compound formed by the sputtering is deposited also on the side face of the target member and the upper surface of backing plate, which are at the identical potential with that of the target member.

The present inventors have found that such abnormal electric discharge can be prevented by providing other insulating members 4$'$ and 4$''$ to coat the side face of the target member 1 and the upper surface of the backing plate 6 (the surface around the target member 1 when placed on the backing plate), in addition to the electrically insulating film 4 on the non-sputter area 3 of the target member 1, as shown in Fig. 5.

Insulating material such as glass or ceramic is used for the insulating member and any of shapes may be used so long as the member can coat the entire side face of the target member and the upper surface of the backing plate 6 arround the target member 1 as shown in Fig. 5. The insulating members 4, 4$'$ and 4$''$ or the insulating members 4$'$ and 4$''$ may be formed integrally. As shown in the figure, if the backing plate 6 is covered with an earth shield 8, the width of the insulating member to coat the upper surface of the backing plate 6 is usually not less than twice and, preferably, not less than five times of the distance between the inner end of the earth shield 8 and the side face of the target member 1. Any thickness is sufficient so long as it can suppress dielectric breakdown during sputtering (usually not less than 50 $\mu$m), but it is preferably not less than 1 mm and, more preferably, within a range from 1 to 3 mm in view of the handling properties.

As a method of providing the electrically insulating member 4$'$ and 4$''$, the method by means of adhesive or screw, as described above, may be used.

In the present invention, a thin film of the compound produced from the target substance and the reactive gas is formed on a substrate or on a layer provided on the substrate by sputtering the target as described above in the presence of the reactive gas by a method of DC magnetron reactive sputtering. The sputtering target according to the present invention may be applied without any restriction to any of technical fields to which usual reactive sputtering is applied. For example, the sputtering target according to the present invention may be effectively used for forming a thin film of the compound derived from the target substance and the reactive gas in the production of transparent electroconductive films, display elements, polarizing films, optical disks, etc.

Application to the production of an optical disk will be exemplified below.

The substrate of an optical disk is usually made of a resin such as polycarbonate resins, acryl resins and polyolefin resins. The thickness of the substrate is generally from about 1 mm to about 2 mm.

The constituent of the recording layer to be provided on the substrate is not practically restricted and any of the known constituent for the recording layer may be employed. In the case of magnetooptical disk, for example, an amorphous alloy comprising a rare earth element and a transition metal such as TbFe, TbFeCo, TbCo and DyFeCo, polycrystalline perpendicular magnetizing film such as MnBi and MnCuBi, etc. are used for the magnetic recording layer. The magnetic recording layer may be either of single-layered structure or two- or multi-layered structure such as GdTbFe/TbFe.

An interference layer (dielectric layer) may be provided between the substrate and and the magnetic recording layer. The interference layer is a transparent layer of a high refractive index and shows interfering effect on the light, and therefore, serves the role of reducing the noise to improve C/N ratio by lowering the reflectance due to its interfering effect on light. The interference layer may be either of single-layered structure or multi-layered structure and constituted with a metal oxide or a metal nitride.

As the metal oxide, $Al_2O_3$, $Ta_2O_5$, $SiO_2$, SiO, $TiO_2$, etc. or a mixture thereof and a compound oxide of Al-Ta-O may be used. It is further possible to use an oxide formed by combining an oxide of other elements such as Ti, Zr, W, Mo and Yb singly or together with Al or Ta with the metal oxide described above. The interference layer made of these metal oxides are dense, therefore, can effectively prevent the permeation thereinto of water and oxygen from the outside, and has a high corrosion resistance and no appreciable interaction with a reflective layer. The interference layer is also excellent in adhesion to a resin substrate.

As the metal nitride, silicon nitride, aluminum nitride, etc. may be mentioned. Silicon nitride is preferred because of its denseness sufficient for preventing the permeation of water or oxygen from the outside.

The preferred thickness of the interference layer comprising the metal oxide or metal nitride depends on its refractive index, and is usually from about 400 to about 1500 Å preferably from about 500 to 1000 Å.

A protective layer comprising the same material for the interference layer, i.e. a dielectric layer, may be provided on the opposite side of the magnetic recording layer with respect to the interference layer. The dielectric layer usually has a thickness from about 500 to about 1500 Å.

When a magnetooptical disk having a reflective layer is intended, a reflective layer comprising a simple substance of a metal or an alloy of a metal having a high reflectance such as Al and Cu is provided on a recording layer directly or through a dielectric layer of a few hundred angstrom thickness.

The typical structures of the magnetooptical disk described above include:
Substrate/Interference Layer/Magnetic Recording Layer/Reflective Layer/Protective Layer, and
Substrate/Interference Layer/Magnetic Recording Layer/Protective Layer.

Another example of the optical disk, to the production of which the target according to the present invention may be applied, is a phase-changeable optical disk. A material which changes its crystalline state and its reflectance by rapid cooling or gradual cooling after the application of laser beam is used for the recording layer of the phase-changeable optical disk. As such materials, organic pigments and chalcogenides are used.

The typical structures of the phase-changeable optical disk include:

Substrate/Interference Layer/Recording Layer/Reflective Layer/Protective Layer,
Substrate/Interference Layer/Recording Layer/Interference Layer /Reflective Layer, and
Substrate/Interference Layer/Recording Layer/Protective Layer.

The target according to the present invention is applied to the formation of a thin layer of a metal oxide, metal nitride, etc. functioning as the interference layer, the dielectric layer or the protective layer of the optical disks described above.

The thin layer of a metal oxide or metal nitride is formed on a substrate or a layer provided on the substrate by subjecting the target of the present invention to DC magnetron reactive sputtering in an atmosphere of an inert gas and oxygen gas or nitrogen gas. For example, a thin layer of $Ta_2O_5$ is formed by subjecting a metallic Ta target to DC magnetron reactive sputtering in an atmosphere of oxygen and argon gas.

The DC magnetron reactive sputtering is preferably conducted under conditions of a sputter gas pressure of not higher than $10 \times 10^{-3}$ Torr, more preferably $1 \times 10^{-3}$ to $5 \times 10^{-3}$ Torr, a film deposition speed of 0.1 to 100 Å/Sec, a potential of 300 to 800 V, and a power density of 0.2 to 30 $W/cm^2$, more preferably 1 to 15 $W/cm^2$.

When the target of the present invention is used in forming a thin layer of a metal oxide or a metal nitride as the interference layer or dielectric layer of the optical disks described above, abnormal electric discharge attributable to the deposition of a insulating compound on the non-sputter area during sputtering can be effectively prevented. The use of the target of the present invention in forming an interference layer or dielectric layer of an optical disk by DC magnetron reactive sputtering enables to the formation of the layer with less defects, thereby remarkably improving the yield and the productivity of optical disks.

The present invention will now be explained more specifically referring to examples but it should be noted that the invention is not restricted to the following examples unless it does not go beyond the scope thereof.

Example 1 :

A Ta target was sputtered at $2W/cm^2$ in an $O_2/Ar$ atmosphere of $5 \times 10^{-3}$ Torr.

In the case of not coating the non-sputter area of the target with glass, insulating films were deposited on the non-sputter areas and abnormal electric discharge was caused at a rate of once per five minutes. On the other hand, in a case of coating the non-sputter area with glass of 3 mm thickness, occurrence of abnormal electric discharge was reduced to once per one hour.

## Example 2 :

A Ta target was sputtered at 2W/cm² in an O₂/Ar atmosphere of 5 × 10⁻³ Torr.

In a case of not replacing the non-sputter area of the target with an insulating integral member, insulating films were deposited on the non-sputter areas and abnormal electric discharge was caused at a rate of once per five minutes. On the other hand, in the case of constituting the non-sputter area with glass 7 as shown in Fig. 2, occurrence of abnormal electric discharge was reduced to once per two hours.

## Example 3 :

A Ta target was sputtered at 2W/cm² in an O₂/Ar atmosphere of 5 × 10⁻³ Torr. In a case of not coating the non-sputter area of the target with glass, insulating films were deposited on the non-sputter area and abnormal electric discharge was caused at a rate of once per five minutes. On the other hand, in a case of coating the non-sputter area with glass (2.8 mm thickness), occurrence of abnormal electric discharge was reduced to once per one hour. Further, as shown in Fig. 4, in a case of coating the non-sputter area with glass provided with bevels in which b is 0.2 mm, c is 2.8 mm and θ is 31°, occurrence of abnormal electric discharge was further reduced to once per two hours.

## Example 4 :

A Ta target was placed on a backing plate covered with an earth shield and sputtered at 2W/cm² in an O₂/Ar atmosphere of 5 × 10⁻³ Torr. The distance between the inner end of the earth shield and the side face of the target was 2 mm. In a case of not coating the non-sputter area of the target with glass, insulating films were deposited on the non-sputter area and abnormal electric discharge was caused at a rate of once per five minutes. On the other hand, in a case of coating the non-sputter area with glass (2 mm thickness), occurrence of abnormal electric discharge was reduced to once per one hour. Further, glass of 6 mm width which was substantially the same as the thickness of the target was coated on the side face of the target, while glass of 10 mm width was coated so as to coat the upper surface of the backing plate around the target. The thickness for both of glass member was 2 mm. Occurrence of abnormal electric discharge was further reduced to once per 2.5 hours.

## Example 5 :

A polycarbonate substrate of 130 mmø was introduced into an in-line sputtering apparatus. By using a mixed gas of Ar and O₂, the Ta target of the present invention used in Example 1 was subjected to DC magnetron reactive sputtering to form a $Ta_2O_5$ interference layer of 800 Å thickness on the substrate. The frequency of abnormal electric discharge was once per 1 hour.

Then, a $Tb_{22}(Fe_{90}Co_{10})_{78}$ recording layer of 300 Å thickness was formed on the interference layer by sputtering of a TbFeCo target in Ar gas. An Al target was then sputtered in Ar gas to form a Al reflective layer of 300 Å thickness on the recording layer.

Finally, a tantalum oxide protective layer of 400 Å thickness was formed on the reflective layer by subjecting the Ta target of the present invention used in Example 1 to DC magnetron reactive sputtering in an Ar/O₂ atmosphere of 5 × 10⁻³ Torr to give a magnetooptical disk. The frequency of abnormal electric discharge was once per 1 hour.

Defects of these disks manufactured by this process remained very low level compared with those manufactured without the Ta target of the present invention.

Other than initial value of error rate, these disks showed good performance on the increase of error rate by aging test. After 2000 hours exposure to 85 °C/85 % RH, the increase ratio of error rate of the disk manufactured by this process is about 2, while 5 in case of disk manufactured without the Ta target of the present invention.

## Claims

1. A sputtering target for DC magnetron reactive sputtering, which is formed to be placed on the upper surface of a backing plate in a DC magnetron reactive sputtering apparatus and comprises a target member to be sputtered and a plurality of electrically insulating members provided to coat the upper surface of the target member or the upper surface of the backing plate so as to prevent the deposition of a metal compound or a nonmetal compound formed by DC magnetron reactive sputtering on non-sputter areas of the target member.

2. The sputtering target according to claim 1, wherein the electrically insulating member is an electrically insulating film of not less than 50 μm thickness coated on the non-sputter areas of the target member.

3. The sputtering target according to claim 1, wherein the electrically insulating member is an electrically insulating integral member which constitutes the non-sputter area of the target member to coat the upper surface of the backing plate.

4. The sputtering target according to claim 2, wherein the electrically insulating film is provided with bevels at the edges facing to the non-sputter areas.

5. The sputtering target according to claim 2 or 4, wherein another insulating member is provided on the side face of the target member so as to prevent the deposition of the metal compound or the nonmetal compound on the side face and the upper surface of the backing plate.

6. A process for forming a thin layer of a metal compound or a nonmetal compound by DC magnetron reactive sputtering, which comprises sputtering the target according to any one of claims 1 to 5 to sputter a target substance and reacting the sputtered target substance with a reactive gas, thereby depositing the metal compound or the nonmetal compound produced by the reaction on a substrate or a layer on the substrate.

7. An optical disk having a layer of a metal compound or a nonmetal compound formed by the process according to claim 6.

## Fig. 1

## Fig. 2

## Fig. 3

# Fig. 4

# Fig. 5

# Fig. 6

## Fig. 7(a)

## Fig. 7(b)

## Fig. 8(a)

## Fig. 8(b)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 5, no. 148 (C-72)[820], 18th September 1981; & JP-A-56 081 675 (MATSUSHITA DENKI SANGYO K.K.) 03-07-1981 * Whole document * | 1,6 | C 23 C 14/34 |
| A | US-A-4 468 313 (K. OKUMURA et al.) * Figures 2,3; column 3, lines 27-38 * | 1,6 | |
| A | EP-A-0 124 075 (TOSHIBA K.K.) * Figures 3,5,6 * | 1,6 | |
| A | PATENT ABSTRACTS OF JAPAN, vol. 10, no. 139 (C-348)[2196], 22nd May 1986; & JP-A-60 262 968 (NIPPON SHINKU GIJUTSU) 26-12-1985 * Whole document * | 1,6 | |
| | | | **TECHNICAL FIELDS SEARCHED (Int. Cl.5)** |
| | | | C 23 C |

The present search report has been drawn up for all claims

| Place of search | Date of completion of search | Examiner |
|---|---|---|
| The Hague | 20 November 90 | JOFFREAU P.O. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document